# EUROPEAN PATENT APPLICATION

(11) **EP 4 668 331 A1**
(43) Date of publication of application: **24.12.2025**
(21) Application number: 25181205.3
(22) Date of filing: 05.06.2025
(51) Int. Cl.: H01L 23/522, H01L 21/768, H10D 88/00, H01L 23/48

(54) **MULTI-LAYER CONDUCTIVE VIAS WITH ETCH-SELECTIVE LINERS**

(30) Priority: 14.06.2024 US 202418743579
(71) Applicant: Intel Corporation, Santa Clara, CA 95054 (US)
(72) Inventor: SHARMA, Abhishek Anil, Portland, 97229 (US); GOMES, Wilfred, Portland, 97229 (US); MURTHY, Anand, Portland, 97229 (US); SUTHRAM, Sagar, Portland, 97229 (US); RANADE, Pushkar, San Jose, 95134 (US); GHANI, Tahir, Portland, 97229 (US)
(74) Representative: 2SPL Patentanwälte PartG mbB

(57) **Abstract**

An integrated circuit (IC) device includes a first metallization layer, a second metallization layer, and a transistor layer between the first and second metallization layers. The transistor layer includes a first gate structure and a second gate structure. A conductive via between the first gate structure and the second gate structure extends through the first metallization layer and extends at least partially into the second metallization layer.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component becomes increasingly significant.

### Brief Description of the Drawings

Embodiments will be readily understood by the following detailed description in conjunction with the accompanying drawings.
FIGS. 1A and 1B are schematic illustrations of cross-sectional views of an example transistor, according to some embodiments of the present disclosure.
FIG. 2 is a cross-section of an IC device including multi-layer conductive vias with etch-selective liners, according to some embodiments of the present disclosure.
FIG. 3 is a cross-section of an alternative IC device including multi-layer conductive vias with etch-selective liners, according to some embodiments of the present disclosure.
FIG. 4 is a flow diagram of an example process for manufacturing an IC device including multi-layer conductive vias with etch-selective liners, according to some embodiments of the present disclosure.
FIGS. 5A-5H are side, cross-sectional views of various stages of the example process of FIG. 4, according to some embodiments of the present disclosure.
FIGS. 6A and 6B are top views of a wafer and dies that include one or more IC devices having one or more multi-layer conductive vias with one or more etch-selective liners, in accordance with any of the embodiments disclosed herein.
FIG. 7 is a cross-sectional side view of an IC device that includes one or more IC devices having one or more multi-layer conductive vias with one or more etch-selective liners, in accordance with any of the embodiments disclosed herein.
FIG. 8 is a cross-sectional side view of an IC device assembly that includes one or more IC devices having one or more multi-layer conductive vias with one or more etch-selective liners, in accordance with any of the embodiments disclosed herein.
FIG. 9 is a block diagram of an example computing device that includes one or more IC devices having one or more multi-layer conductive vias with one or more etch-selective liners, in accordance with any of the embodiments disclosed herein.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

An IC device typically utilizes interconnect layers with conductive interconnects to connect components in the IC device (e.g., transistors, capacitors, or resistors, e.g. in a device layer of the IC device), and/or communicate power, data, and ground signals between the IC device and external devices. Common types of conductive interconnects include copper and copper alloy interconnects. In some IC designs, interconnect layers may be formed on both sides of the transistors, e.g., on the front side and on the back side of an IC device or on the front side and on the back side of a transistor layer of an IC device. For example, in some IC devices, gate, source, and/or drain contacts of one or more transistors may be moved to the back side of the IC device. In some IC devices, power and/or signal connections may be formed on the back side of the IC device and extend through the transistor layer to the front side of the IC device.

A plurality of interconnect layers stacked above one another may be referred to as an "interconnect stack" or a "metallization stack." As noted above, in some device architectures, both front side interconnect layers and back side interconnect layers, also referred to as front side metallization stack (or, simply, a "front side metallization") and back side metallization stack (or, simply, a "back side metallization"), are included. The front and back side metallization may be provided on opposite sides of a transistor layer of an IC device. Interconnect layers, also referred to as "metal layers," may include conductive interconnects in the form of electrically conductive lines, also referred to as "conductive trenches," which provide connectivity across a given interconnect layer, and electrically conductive vias (or, simply, "vias") that provide electrical connectivity between different interconnect layers. In general, the term "conductive line" may be used to describe an electrically conductive element isolated by an insulator material (e.g., a low-k dielectric) that is provided in a plane parallel to the plane of an IC die/chip or a support structure over which an IC structure is provided, while the term "conductive via" may be used to describe an electrically conductive element that interconnects two or more conductive lines of different levels of a metallization stack, or a component of the transistor layer and one or more conductive lines of a metallization layer. Together, conductive lines and conductive vias may be referred to as "interconnects," where the term "interconnect" may be used to describe any element formed of an electrically conductive material for providing electrical connectivity to/from one or more components associated with an IC or/and between various such components.

In some IC devices, to route signals through an interconnect stack, vias can be joined together with lines to route the signals through the stack. In some cases, at least some of the vias and lines may include one or more conductive liners. Although the deposition of conductive liners in cavities in which the vias and lines are formed can aid in the successful formation of vias and/or lines in the cavities, the liners may also increase the series resistance of the circuit path along which the signals are communicated, potentially causing issues such as undesirable heat generation, inadequate power transmission, and/or data signal loss.

Furthermore, as interconnect layers in IC devices are manufactured with conductive lines and vias having smaller sizes and pitches to accommodate smaller IC devices, it becomes increasingly difficult to properly align conductive vias with conductive lines in a given interconnect layer. For example, during manufacturing of an IC device, the edges of a conductive via may be misaligned with a conductive line due to limitations or variations in manufacturing processes used to manufacture the IC device (e.g., due to limits to precision of photolithography processes used, variations in geometry of substrates on or in which the IC device is built, and so on). Misalignment can be increased because of bow, warp, or distortion in shapes of IC device interconnect layers or components from ideal shapes (for example, due to heating or cooling during manufacturing processes, e.g., due to differences in thermal expansion between layers or components). Misalignment of a conductive via or a conductive via contacting a wrong interconnect feature in an IC device may cause short circuits when the IC device is in use, resulting in degraded electrical performance. One solution to address this issue is to reduce the sizes of conductive vias used in IC devices, for example, by making the vias narrower. However, reduction of via sizes results in a further increase in resistance and reduced yield during manufacturing.

Disclosed herein are IC devices that aim to improve on at least some of the challenges described above. In one aspect, an IC device may include a first interconnect layer (e.g., a front side interconnect layer), a second interconnect layer (e.g., a back side interconnect layer), and a transistor layer (e.g., a device layer comprising transistors and, optionally, other components such as capacitors or resistors) between the first interconnect layer and the second interconnect layer. The transistor layer may include a first gate structure and a second gate structure. The IC device may further include a conductive via between the first gate structure and the second gate structure, the conductive via extending through the first interconnect layer and at least partially into the second interconnect layer. Advantageously, the conductive via may extend through the transistor layer and through or within multiple interconnect layers, allowing for signals (e.g., power, data, and/or ground signals) to be conveyed through a given circuit path including the conductive via in an IC device with decreased resistance due to the signals passing through a reduced amount of conductive liner material (e.g., relative to conveying signals through multiple conductive vias with multiple conductive liners).

A dielectric liner may be adjacent to at least a portion of the conductive via of such an IC device (e.g., adjacent to a part of a sidewall of the conductive via). The dielectric liner may include a dielectric material. The dielectric material may include at least one of hafnium, tantalum, aluminum, and silicon, and may further include at least one of oxygen and nitrogen. The dielectric liner may have a lower etch selectivity than (e.g., be etched relatively less rapidly than) copper or another via fill material. The dielectric liner may aid in alignment of the conductive via during its formation so that the conductive via may be reliably aligned with adjacent interconnects (e.g., conductive lines and/or other conductive vias), allowing for reliable power and/or data signal transmission through the IC device.

In the following, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because, as is common in the field of transistors, designations of source and drain are often interchangeable. Therefore, descriptions of some illustrative embodiments of the source and drain regions/contacts provided herein are applicable to embodiments where the designation of source and drain regions/contacts may be reversed.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. As used herein, a "logic state" (or, alternatively, a "state" or a "bit" value) of a memory cell may refer to one of a finite number of states that the cell can have, e.g., logic states "1" and "0," each state represented by a different voltage of the capacitor of the cell, while "READ" and "WRITE" memory access or operations refer to, respectively, determining/sensing a logic state of a memory cell and programming/setting a logic state of a memory cell. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

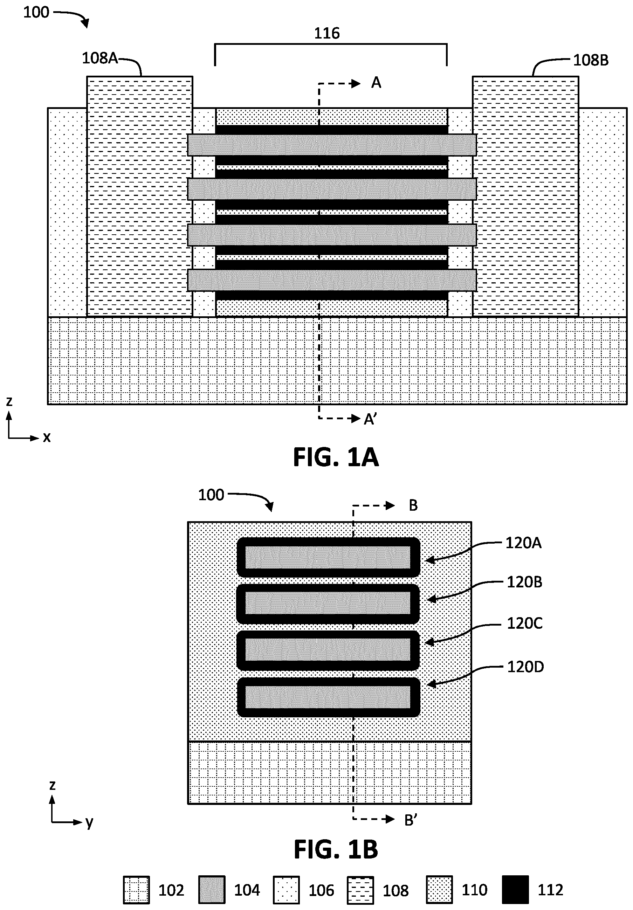

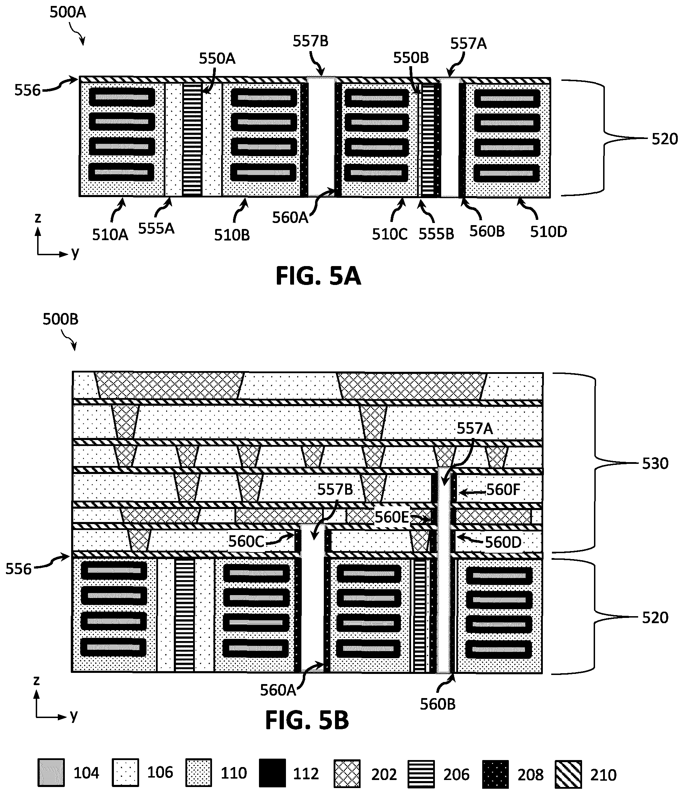

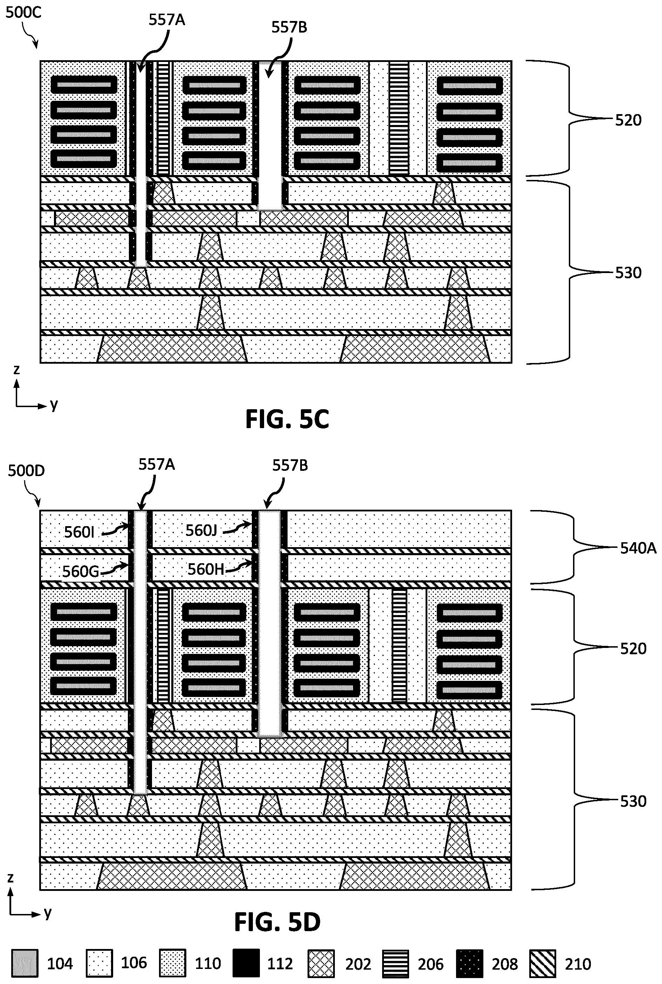

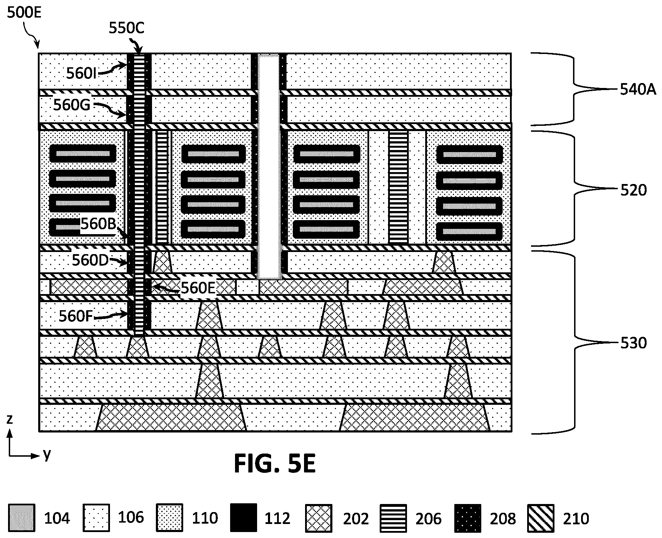

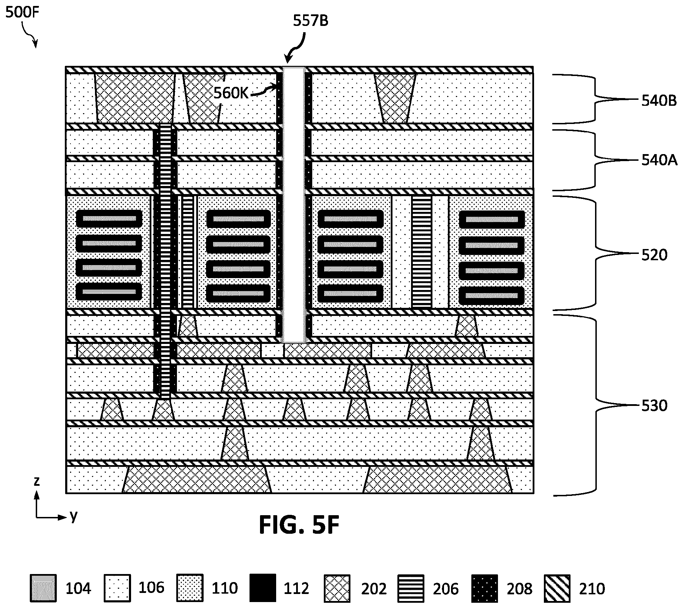

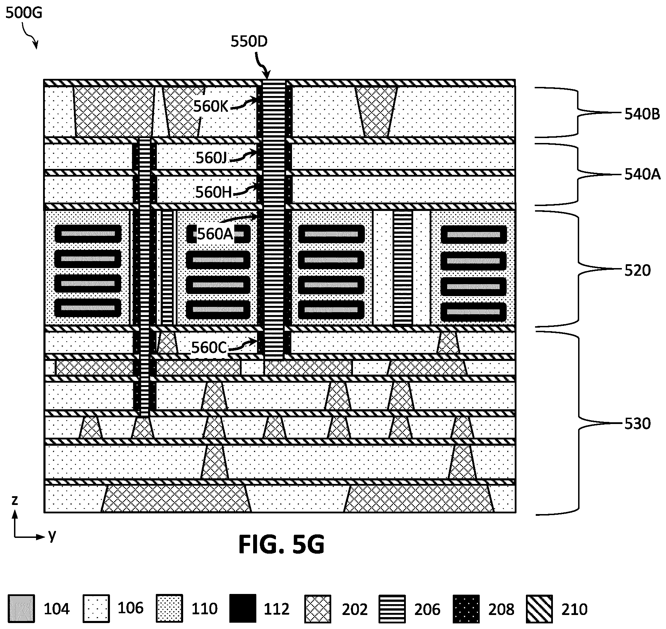

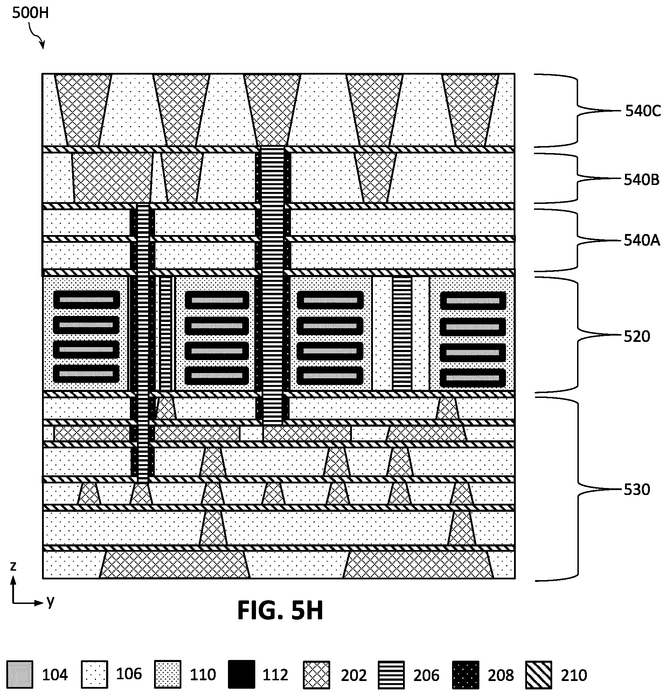

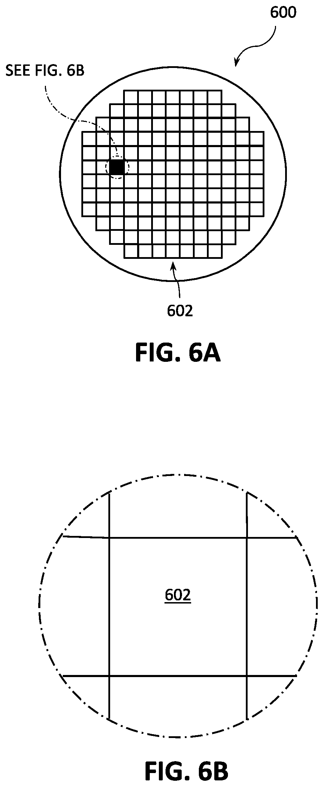

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, the phrase "FIG. 1" may be used to refer to the collection of drawings of FIGS. 1A-1B, phrase "FIG. 5" may be used to refer to the collection of drawings of FIGS. 5A-5H, the phrase "FIG. 6" may be used to refer to the collection of drawings of FIGS. 6A-6B, etc.

In the drawings, some example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects or features could also be visible, e.g., not-perfectly straight edges of materials, tapered vias or other openings, rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices as described herein (e.g., various IC devices having one or more multi-layer conductive vias with one or more etch-selective liners) may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

FIGS. 1A-1B illustrate an example architecture of a nanoribbon-based transistor. FIG. 1A is a cross-section across a transistor 100 showing a channel, a source, a gate region, and a drain. FIG. 1B is a cross-section across the gate region of the transistor 100. FIG. 1B is a cross-section through the plane A-A' in FIG. 1A, and FIG. 1A is a cross-section through the plane B-B' in FIG. 1B.

A number of elements are referred to in descriptions of FIGS. 1A-1B, 2, 3, and 5A-5H with reference numerals which correspond to different patterns illustrated in the figures, and legends are included at the bottoms of the pages including FIGS. 1A-1B, 2, 3, and 5A-5H, showing the correspondence between the reference numerals and patterns. The legend on the page including FIGS. 1A and 1B illustrates that FIGS. 1A and 1B use different patterns to show a support structure 102, a channel material 104, a dielectric material 106, a source or drain (S/D) region 108, a gate electrode 110, and a gate dielectric 112.

In general, implementations of the present disclosure may be formed or carried out on a support structure, e.g., the support structure 102 illustrated in FIG. 1. The support structure 102 may be, e.g., a substrate, a die, a wafer or a chip. For example, the support structure 102 may be the wafer 600 of FIG. 6A, discussed below, and may be, or be included in, a die, e.g., the singulated die 602 of FIG. 6B, as discussed below. The support structure 102 extends along the x-y plane in the coordinate system shown in FIG. 1. In some embodiments, a support structure 102 may be used during a fabrication process and later removed. For example, a top side (e.g., front side) of the transistor 100 may be attached to a second support structure (e.g., a second one of the support structures 102, which may be referred to as a carrier structure), and the support structure 102 over which the transistor 100 is formed may be removed to expose a bottom side (e.g., back side) of the transistor 100.

In some embodiments, the support structure 102 may be a substrate that includes silicon and/or hafnium. More generally, the support structure 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the support structure 102 may be non-crystalline. In some embodiments, the support structure 102 may be a printed circuit board (PCB) substrate. Although a few examples of materials from which the support structure 102 may be formed are described here, any material that may serve as a foundation upon which a semiconductor device as described herein (e.g., a semiconductor device including one or more fin-shaped field effect transistors, nanoribbon transistors, or nanowire transistors) may be built falls within the spirit and scope of the present disclosure.

In FIGS. 1A and 1B, the transistor 100 is formed over the support structure 102. The transistor 100 includes a channel material 104 formed into four nanoribbons stacked on top of each other. In other examples, the transistor 100 may include more or fewer nanoribbons, e.g., one, two, three, five, six or more nanoribbons. The channel material 104 may be a semiconductor, and may include silicon or other semiconductor materials described herein.

The transistor 100 includes nanoribbons 120A, 120B, 120C, and 120D, referred to collectively as nanoribbons 120 or nanoribbon channels, or individually as a nanoribbon 120 or nanoribbon channel. Each nanoribbon 120 is at a different height in the z-direction in the orientation shown in FIGS. 1A and 1B, i.e., a different distance from the support structure 102, where the nanoribbon 120A is the greatest distance from the support structure 102, and the nanoribbon 120D is the smallest distance from the support structure 102. S/D regions 108A and 108B are formed at either end of the nanoribbons 120, as illustrated in FIG. 1A.

In general, to form nanoribbon channels such as the nanoribbons 120, alternating layers of the channel material 104 and a sacrificial material are deposited over the support structure 102. The sacrificial material is removed from the stack and replaced with other material, e.g., material for forming a gate stack 116, so the sacrificial material is not shown in FIG. 1. The channel material 104 and sacrificial materials include different materials. In one example, the channel material 104 is silicon, while the sacrificial material includes silicon and germanium. The sacrificial material may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material (or substantially monocrystalline layers) may be formed over each other. In different embodiments, the channel material 104 and/or the sacrificial material may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both N-type metal oxide semiconductor (NMOS) transistors and P-type metal oxide semiconductor (PMOS) transistors, e.g., alternating rows of NMOS and PMOS transistors. NMOS and PMOS transistors can use different groups of channel material 104, e.g., silicon may be used to form an N-type semiconductor channel, while silicon germanium may be used to form a P-type semiconductor channel. In some embodiments, a single channel material 104 is used (e.g., silicon), and different portions (e.g., channel material to form different transistors) may include different dopants, e.g., N-type dopants for NMOS transistors and P-type dopants for PMOS transistors.

The S/D regions 108 may be formed from one or more layers of doped semiconductors, metals, metal alloys, or other materials. In some embodiments described herein, the S/D regions 108 may include a doped semiconductor, such as silicon or another semiconductor doped with an N-type dopant or a P-type dopant. In some embodiments, the S/D regions 108 may include multiple layers with different levels of conductivity, e.g., a doped semiconductor followed by a more highly doped semiconductor, or a semiconductor followed by metal.

A portion (e.g., a central portion) of each of the nanoribbons 120 is surrounded by a gate stack 116, which in this example, includes a gate electrode 110 and gate dielectric 112. Nanoribbon transistors often include a gate dielectric 112 that surrounds the nanoribbons 120, and a gate electrode 110 that surrounds the gate dielectric 112. While not specifically shown, in some embodiments, the gate dielectric 112 around each nanoribbon 120 includes multiple layers, e.g., an oxide layer and a high-k dielectric layer. The oxide layer may be grown directly on the nanoribbons 120, and the high-k dielectric may surround the oxide. The oxide may include oxygen in combination with the channel material 104. For example, if the nanoribbon channels are formed from silicon, the gate dielectric 112 may include a layer of silicon oxide. The high-k dielectric may be formed over the oxide. The gate electrode 110 surrounds the gate dielectric 112, e.g., the high-k dielectric (if included). In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

In various embodiments, the gate dielectric 112 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, the gate dielectric 112 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D regions 108 are filled in with a dielectric material 106. The dielectric material 106 may include a low-k dielectric or a high-k dielectric. In some embodiments, the dielectric material 106 may include nitrogen. The dielectric material 106 may include silicon and nitrogen, e.g., silicon nitride. In some embodiments, the dielectric material 106 may include one or more dielectric materials that may include, but are not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials include, but are not limited to silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

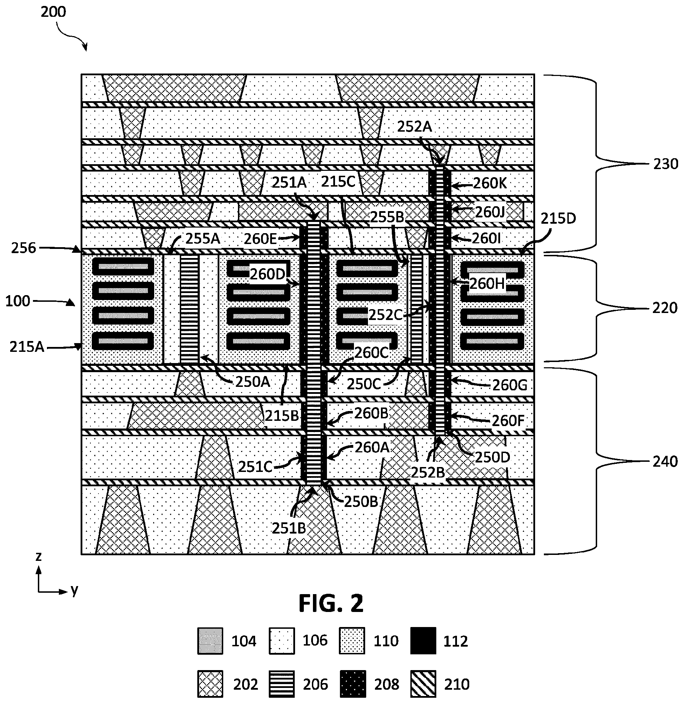

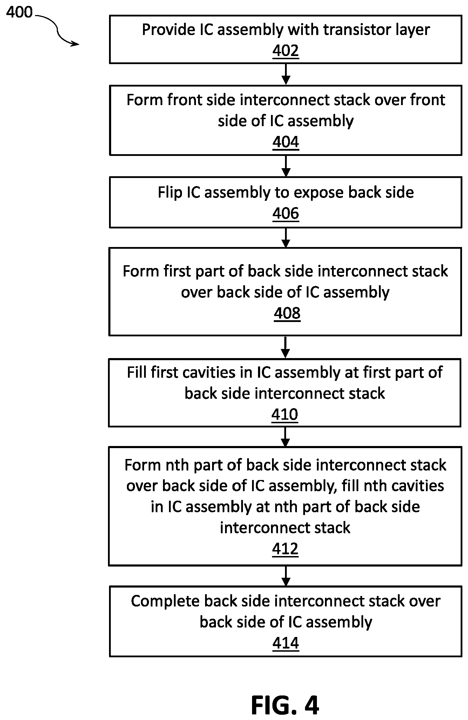

FIG. 1 illustrates a single nanoribbon transistor 100. In IC devices, many similar or identical transistors may be arranged in a device layer (such as in a transistor layer, or in a transistor assembly of a device layer). The dielectric material 106 and/or other materials may provide isolation between different transistors, or between other conductive materials in or near the device layer. As described with respect to FIGS. 2, 3, 5, and in various portions of this disclosure, IC devices can include vias that can extend through dielectric material 106 between different transistors, and methods of manufacturing such IC devices can involve processes described below (e.g., with reference to FIGS. 4 and 5), which can allow for one or more of the benefits or advantages described above to be realized.

FIG. 2 is a cross-section of an example IC device 200 including a transistor layer 220 between a front side interconnect stack 230 (including front side interconnect layers) and a back side interconnect stack 240 (including back side interconnect layers), according to some embodiments of the present disclosure. The transistor layer 220 may be an example of a device layer, and may include transistors 100, which may be the same as the transistors 100 described above with reference to FIG. 1. As shown, four transistors 100 (shown as first nanoribbon transistor 215A, second nanoribbon transistor 215B, third nanoribbon transistor 215C, and fourth nanoribbon transistor 215D) are included in the transistor layer 220, although in other embodiments, fewer or more transistors 100 may be provided in the transistor layer 220. The transistor layer 220 may function as, include, or be part of a logic or memory device.

The transistors 100 may be separated by dielectric material 106 (e.g., including dielectric material 106 present in a first zone 255A between first and second nanoribbon transistors 215A, 215B, and in a second zone 255B between third and fourth nanoribbon transistors 215C, 215D). The dielectric material 106 may physically and/or electrically isolate individual transistors 100 or groups of transistors 100 from one another.

Conductive structures (e.g., vias) may extend between transistors 100 and/or through the dielectric material 106 in the transistor layer 220 (e.g., with portions of the dielectric material 106 physically and/or electrically separating or isolating the conductive structures from transistors 100 in the transistor layer 220). As shown in FIG. 2, a first conductive structure 250A is present within dielectric material 106 of the first zone 255A (e.g., between first and second nanoribbon transistors 215A, 215B, or between gate structures (including the gate electrode 110 and the gate dielectric 112) of the first and second nanoribbon transistors 215A, 215B). Additionally, a second conductive structure 250B is present between the second and third nanoribbon transistors 215B, 215C, or between gate structures (including the gate electrode 110 and the gate dielectric 112) of the second and third nanoribbon transistors 215B, 215C) (e.g., a plane (e.g., an imaginary plane) substantially perpendicular to a longitudinal axis of the second conductive structure 250B can include portions of the second and third nanoribbon transistors 215B, 215C and a portion of the second conductive structure 250B). The second conductive structure 250B is a multi-level structure (e.g., an elongated multi-level via), and extends at least partially into or through one or more interconnect layers of the front side interconnect stack 230 (e.g., to a first end 251A) and at least partially into or through one or more interconnect layers of the back side interconnect stack 240 (e.g., to a second end 251B). In some embodiments, the second conductive structure 250B may extend at least partially into or through one or more interconnect layers of the front side interconnect stack 230 or at least partially into or through one or more interconnect layers of the back side interconnect stack 240. The second conductive structure 250B may taper in width along a length or height between the first end 251A and the second end 251B (e.g., taper or become narrower from the first end 251A to the second end 251B).

Furthermore, third and fourth conductive structures 250C, 250D are present within dielectric material 106 of the second zone 255B (e.g., between the third and fourth nanoribbon transistors 215C, 215D, or between gate structures (including the gate electrode 110 and the gate dielectric 112) of the third and fourth nanoribbon transistors 215C, 215D). Similarly to the second conductive structure 250B, the fourth conductive structure 250D is shown in FIG. 2 as a multi-level structure (e.g., an elongated multi-level via), and may extend at least partially into or through one or more interconnect layers of the front side interconnect stack 230 (e.g., to a first end 252A) and at least partially into or through one or more interconnect layers of the back side interconnect stack 240 (e.g., to a second end 252B). In some embodiments, the fourth conductive structure 250D may extend at least partially into or through one or more interconnect layers of the front side interconnect stack 230 or at least partially into or through one or more interconnect layers of the back side interconnect stack 240. The fourth conductive structure 250D may taper in width along a length or height between the first end 252A and the second end 252B (e.g., taper or become narrower from the first end 252A to the second end 252B). The first conductive structure 250A and the third conductive structure 250C are shown in FIG. 2 as having ends in or adjacent to the transistor layer 220, although in other embodiments, the first conductive structure 250A and/or the third conductive structure 250C may extend at least partially into or through one or more interconnect layers of the front side interconnect stack 230 and/or at least partially into or through one or more interconnect layers on the back side interconnect stack 240. The conductive structures 250A, 250B, 250C, 250D may, for example, connect (e.g., physically and/or electrically connect) components of the front side interconnect stack 230 and components of the back side interconnect stack 240 (e.g., for power, ground, and/or signal delivery or routing). In some embodiments, any of the second conductive structure 250B and the fourth conductive structure 250D may have an aspect ratio between about 3:1 and 100:1 or a few hundreds to one. In some embodiments, any of the second conductive structure 250B and the fourth conductive structure 250D may have a width between about 10 nanometers and 30 nanometers, or between about 50 nanometers and 150 nanometers. In the embodiments where the second conductive structure 250B and the fourth conductive structure 250D extend between nanoribbons or fins of the channel material 104, their width may not be greater than half of the pitch of the nanoribbons or fins.

The conductive structures 250A-250D may include a conductive material 206. The conductive material 206 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the conductive material 206 may include one or more electrically conductive alloys, oxides, or carbides of one or more metals. In some embodiments, the conductive material 206 may include a conductive material that does not include a metal. While FIG. 2 illustrates the same conductive material 206 for each of the conductive structures 250A-250D, any suitable conductive material may be used. For example, different materials may be used for different ones of the conductive structures 250A-250D, or ones of the conductive structures 250A-250D may include multiple conductive materials, e.g., a first conductive material as a conductive liner (not shown), and a second conductive material as a conductive fill material. The conductive liner, if present, may aid in the successful formation of the conductive structures 250A-250D in the IC device 200. The second and fourth conductive structures 250B, 250D, being multi-level structures, may allow for power and/or data signals to be conveyed through a given circuit path including the second and fourth conductive structures 250B, 250D with lessened resistance relative to conveying power and/or data signals through multiple conductive structures (e.g., due to the power and/or data signals passing through a reduced amount of conductive liner material (e.g., relative to conveying power and/or data signals through multiple conductive vias having multiple liners, as described above)).

In FIG. 2, the transistor layer 220 is adjacent to and between the front side interconnect stack 230 and the back side interconnect stack 240. The front and back side interconnect stacks 230, 240 may each include one or more interconnect layers, which may include lines and vias, the lines and vias including a conductive material 202. The conductive material 202 may be the same as or similar to the conductive material 206 described above. While FIG. 2 illustrates the same conductive material 202 for the lines and the vias, at each interconnect layer, and for each type of interconnect (e.g., lines or vias), any suitable conductive material may be used. For example, in a given layer, the same conductive material may be used for both lines and vias, or different materials may be used for lines and vias. As another example, in different interconnect layers, different materials may be used for the lines and/or vias, e.g., ruthenium may be included in the lines in one interconnect layer, while copper is included in the lines of another interconnect layer. In various embodiments, line or via structures in the interconnect layers may include multiple conductive materials, e.g., a first metal as a liner, and a second metal as a fill. The conductive material 202 may form conductive pathways to route power, ground, and/or signals to/from various components of the transistor layer 220, front side interconnect stack 230, and/or back side interconnect stack 240. The arrangement of the conductive material 202 in FIG. 2 is merely illustrative, and the conductive pathways in the IC device 200 may be connected to one another in any suitable manner.

The IC device 200 may also include one or more etch stop layers 256. In FIG. 2, etch stop layers 256 are shown on either side of the transistor layer 220 (e.g., a first etch stop layer 256 at or adjacent to a top side of the transistor layer 220, and a second etch stop layer 256 at or adjacent to a bottom side of the transistor layer 220) and in the front side and back side interconnect stacks 230, 240 (e.g., between or adjacent to individual interconnect layers of the front side and back side interconnect stacks 230, 240). The etch stop layers 256 can help to prevent overetching of components of the IC device 200 during various manufacturing processes (e.g., during formation of conductive lines and/or vias in the front side interconnect stack 230 and/or back side interconnect stack 240). The etch stop layers 256 may include an etch stop material 210, which may include any suitable material that can slow or stop undesired etching of components of the IC device 200. For example, the etch stop material 210 may include carbon and silicon, e.g., silicon carbide (SiC). Although a certain number of etch stop layers 256 are shown, this is only to aid in understanding, and it should be understood that the IC device 200 may include additional etch stop layers 256 in order to avoid over etching of lines and/or vias, or may include fewer etch stop layers 256. Furthermore, although the etch stop layers 256 are shown in between lines or vias of some interconnect layers of the front side and back side interconnect layers, it should be understood that there may be openings in portions of the etch stop layers 256 not shown in FIG. 2 (e.g., along different z-y cross-sections of the IC device 200 outside of the view shown in FIG. 2) that may allow for physical and/or electrical communications between certain lines and/or vias in the interconnect layers as required for a given IC device 200.

The lines and vias in the front side and back side interconnect stacks 230, 240 are in the dielectric material 106, which may include any of the materials described above with respect to the dielectric material 106. In some embodiments, different dielectric materials may be included in different ones of the interconnect layers in the interconnect stacks. In some embodiments, multiple dielectric materials may be present in a given interconnect layer.

The IC device 200 may also include liner segments or liners 260A-260K (collectively liner segments 260) adjacent to at least some of the conductive structures. As shown, portions of the second conductive structure 250B (e.g., a sidewall 251C of the second conductive structure 250B between the first end 251A and the second end 251B) are adjacent to liner segments 260A, 260B, 260C, which are in the back side interconnect stack 240 (e.g., in successive interconnect layers of the back side interconnect stack 240), to liner segment 260D, which is in the transistor layer 220, and to liner segment 260E, which is in the front side interconnect stack 230 (e.g., in an interconnect layer of the front side interconnect stack 230 adjacent to the transistor layer 220). The liner segments 260A-260E may be between the etch stop layers 256 (for example, the liner segment 260D may be between the etch stop layers 256 above and below the transistor layer 220, the liner segment 260B may be between etch stop layers 256 in the back side interconnect stack 240, etc.). At least some liner segments 260A-260E may be between the second conductive structure 250B and dielectric material 106 in interconnect layers (for example, the liner segment 260A may be between the second conductive structure 250B and dielectric material 106 in an interconnect layer in the back side interconnect stack 240), between the second conductive structure 250B and conductive material 202 in interconnect layers, and/or between the second conductive structure 250B and a transistor 100 or a portion of a transistor 100 (for example, the liner segment 260D may be between the second conductive structure 250B and the second and third transistors 215B, 215C (e.g., between the second conductive structure 250B and gate structures (such as the gate electrode 110 and the gate dielectric 112) of the second and third transistors 215B, 215C). The liner segments 260A-260E may be considered as multiple separate liner segments 260 or may be considered as parts of a single liner, which may be discontinuous (e.g., separated by portions of the etch stop layers 256).

Portions of the fourth conductive structure 250D (e.g., a sidewall 252C of the fourth conductive structure 250D between the first end 252A and the second end 252B) are adjacent to liner segments 260F, 260G, which are in the back side interconnect stack 240 (e.g., in successive interconnect layers of the back side interconnect stack 240), to liner segment 260H, which is in the transistor layer 220, and to liner segments 260I, 260J, 260K, which are in the front side interconnect stack 230 (e.g., in successive interconnect layers of the front side interconnect stack 230).

The liner segments 260F-260K may be between the etch stop layers 256 (for example, the liner segment 260H may be between etch stop layers 256 above and below the transistor layer 220, the liner segment 260F may be between etch stop layers 256 in the back side interconnect stack 240, etc.). At least some liner segments 260F-260K may be between the fourth conductive structure 250D and dielectric material 106 in interconnect layers (for example, the liner segment 260K may be between the fourth conductive structure 250D and dielectric material 106 in an interconnect layer in the front side interconnect stack 230), between the fourth conductive structure 250D and conductive material 202 in interconnect layers (for example, the liner segment 260F may be between the fourth conductive structure 250D and conductive material 202 in an interconnect layer in the back side interconnect stack 240), between conductive structures (for example, the liner segment 260H may be between the third conductive structure 250C and the fourth conductive structure 250D), and/or between the fourth conductive structure 250D and a transistor 100 or a portion of a transistor 100 (for example, the liner segment 260H may be between the fourth conductive structure 250D and the third and fourth transistors 215C, 215D (e.g., between the fourth conductive structure 250D and gate structures (such as the gate electrode 110 and the gate dielectric 112) of the third and fourth transistors 215C, 215D). The liner segments 260F-260K may be considered as multiple separate liner segments 260 or may be considered as parts of a single liner, which may be discontinuous (e.g., separated by portions of the etch stop layers 256).

The liner segments 260 may include a dielectric liner material 208. The dielectric liner material 208 may include any suitable dielectric material. In some embodiments, the dielectric liner material 208 may include at least one of hafnium, tantalum, aluminum, and silicon. The dielectric liner material 208 may also include at least one of oxygen and nitrogen (e.g., an oxide of hafnium, tantalum, aluminum, and/or silicon, a nitride of hafnium, aluminum, and/or silicon, or an oxynitride of hafnium, aluminum, or silicon). In some embodiments, individual ones of the liner segments 260 may include multiple different liner materials (e.g., within a given material mass, or stacked along the y- or z-axes), or different ones of the liner segments 260 may include different liner materials. In some embodiments, a thickness of one or more of the liner segments 260 may be selected so that double of the thickness is less than about 50% of the second and fourth conductive structures 250B, 250D.

The dielectric liner material 208 may be referred to as an etch-selective liner material, and the liner segments 260 may be referred to as etch-selective liners. The dielectric liner material 208 may have a lower etch selectivity than (e.g., be etched relatively less rapidly than) copper or another via fill material. The liner segments 260A-260K may aid in formation of the second and fourth conductive structures 250B, 250D such that the second and fourth conductive structures 250B, 250D may be reliably aligned with other lines and/or vias (e.g., in the front side and/or back side interconnect stacks 230, 240 to which they are adjacent), as described further below with reference to FIGS. 4 and 5.

Although multiple liner segments 260A-260K are shown at sidewalls 251C, 252C of the second and fourth conductive structures 250B, 250D, in some embodiments, more or fewer liner segments may be adjacent to the sidewalls 251C, 252C of the second and fourth conductive structures 250B, 250D. For example, in some embodiments, the liner segment 260B may not be present, and the portion of the sidewall 251C that would be adjacent to the liner segment 260B may instead be adjacent to only the dielectric material 106 or to another material in the back side interconnect stack 240.

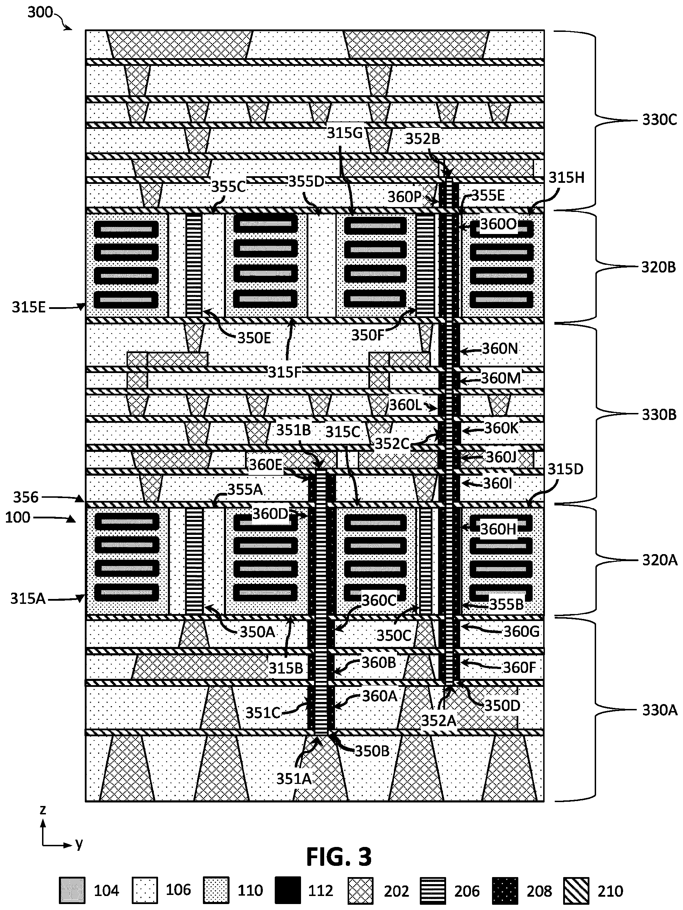

FIG. 3 is a cross-section of an alternative example IC device 300 including first and second transistor layers 320A, 320B between first, second, and third interconnect stacks 330A, 330B, 330C, according to some embodiments of the present disclosure. Parts of the IC device 300, such as the conductive material 202, the conductive material 206, and so on, may be the same as presented for FIG. 2 above, and are not described further here in detail.

The first and second transistor layers 320A, 320B may be examples of device layers, and may include transistors 100, which may be the same as the transistors 100 described above with reference to FIG. 1. As shown, four transistors 100 (shown as first nanoribbon transistor 315A, second nanoribbon transistor 315B, third nanoribbon transistor 315C, and fourth nanoribbon transistor 315D) are included in the first transistor layer 320A, and four transistors 100 (shown as fifth nanoribbon transistor 315E, sixth nanoribbon transistor 315F, seventh nanoribbon transistor 315G, and eighth nanoribbon transistor 315H) are included in the second transistor layer 320B. In other embodiments, fewer or more transistors 100 may be provided in the first and/or second transistor layers 320A, 320B. One or both of the transistor layers 320A, 320B may function as, include, or be part of, one or more logic or memory devices.

The nanoribbon transistors 100 may be separated by dielectric material 106 (e.g., including dielectric material 106 present in a first zone 355A between first and second nanoribbon transistors 315A, 315B, in a second zone 355B between third and fourth nanoribbon transistors 315C, 315D, in a third zone 355C between fifth and sixth nanoribbon transistors 315E, 315F, in a fourth zone 355D between sixth and seventh nanoribbon transistors 315F, 315G, and in a fifth zone 355E between seventh and eighth nanoribbon transistors 315G, 315H). The dielectric material 106 may physically and/or electrically isolate individual transistors 100 or groups of transistors 100 from one another.

Conductive structures (e.g., vias) may extend between transistors 100 and/or through the dielectric material 106 in first and second transistor layers 320A, 320B (e.g., with portions of the dielectric material 106 physically and/or electrically separating or isolating the conductive structures from transistors 100 in the first and second transistor layers 320A, 320B). As shown in FIG. 3, a first conductive structure 350A is present within dielectric material 106 of the first zone 355A (e.g., between first and second nanoribbon transistors 315A, 315B, or between gate structures (including the gate electrode 110 and the gate dielectric 112) of the first and second nanoribbon transistors 315A, 315B). Additionally, a second conductive structure 350B is present between the second and third nanoribbon transistors 315B, 315C, or between gate structures (including the gate electrode 110 and the gate dielectric 112) of the second and third nanoribbon transistors 315B, 315C). The second conductive structure 350B is a multi-level structure (e.g., an elongated multi-level via), and extends at least partially into or through one or more interconnect layers of the first interconnect stack 330A (e.g., to a first end 351A) and at least partially into or through one or more interconnect layers of the second interconnect stack 330B (e.g., to a second end 351B). The second conductive structure 350B may taper in width along a length or height between the first end 351A and the second end 351B (e.g., taper or become narrower from the first end 351A to the second end 351B). Third and fourth conductive structures 350C, 350D are present within dielectric material 106 of the second zone 355B (e.g., between the third and fourth nanoribbon transistors 315C, 315D, or between gate structures (including the gate electrode 110 and the gate dielectric 112) of the third and fourth nanoribbon transistors 315C, 315D). Similarly to the second conductive structure 350B, the fourth conductive structure 350D is shown in FIG. 3 as a multi-level structure (e.g., an elongated multi-level via), and may extend at least partially into or through one or more interconnect layers of the first interconnect stack 330A (e.g., to a first end 352A) and at least partially into or through one or more interconnect layers of the third interconnect stack 330C (e.g., to a second end 352B). The fourth conductive structure 350C may additionally extend through the second transistor layer 320B (e.g., between the seventh and eighth nanoribbon transistors 315G, 315H). The fourth conductive structure 350D may taper in width along a length or height between the first end 352A and the second end 352B (e.g., taper or become narrower from the first end 352A to the second end 352B).

In some embodiments, any of the second conductive structure 350B and the fourth conductive structure 350D may have an aspect ratio between about 3:1 and 100:1 or a few hundreds to one. In some embodiments, any of the second conductive structure 350B and the fourth conductive structure 350D may have a width between about 10 nanometers and 30 nanometers, or between about 50 nanometers and 150 nanometers. In the embodiments where the second conductive structure 350B and the fourth conductive structure 350D extend between nanoribbons or fins of the channel material 104, their width may not be greater than half of the pitch of the nanoribbons or fins.

The first conductive structure 350A and the third conductive structure 350C are shown in FIG. 3 as having ends in or adjacent to the first transistor layer 320A, although in other embodiments, the first conductive structure 350A and/or the third conductive structure 350C may extend at least partially into or through one or more interconnect layers of the first, second, and/or third interconnect stacks 330A, 330B, 330C. A fifth conductive structure 350E and a sixth conductive structure 350F are shown in FIG. 3 as having ends in or adjacent to the second transistor layer 320B, although in other embodiments, the fifth conductive structure 350E and/or the sixth conductive structure 350F may extend at least partially into or through one or more interconnect layers of the first, second, and/or third interconnect stacks 330A, 330B, 330C.

The conductive structures 350A-350F may, for example, connect (e.g., physically and/or electrically connect) components of the first, second, and/or third interconnect stacks 330A, 330B, 330C and/or first and/or second transistor layers 320A, 320B. The conductive structures 350A-350F may include a conductive material 206, which may be the same as or similar to the conductive material 206 described above with reference to FIG. 2. While FIG. 3 illustrates the same conductive material 206 for each of the conductive structures 350A-350F, any suitable conductive material may be used. For example, different materials may be used for different ones of the conductive structures 350A-350F, or ones of the conductive structures 350A-350F may include multiple conductive materials, e.g., a first conductive material as a conductive liner (not shown), and a second conductive material as a conductive fill material. The conductive liner, if present, may aid in the successful formation of the conductive structures 350A-350F in the IC device 300. The second and fourth conductive structures 350B, 350D, being multi-level structures, may allow for power and/or data signals to be conveyed through a given circuit path including the second and fourth conductive structures 350B, 350D with lessened resistance relative to conveying power and/or data signals through multiple conductive structures (e.g., due to the power and/or data signals passing through a reduced amount of conductive liner material (e.g., relative to conveying power and/or data signals through multiple conductive vias having multiple liners, as described above)).

In FIG. 3, the first transistor layer 320A is adjacent to and between the first interconnect stack 330A and the second interconnect stack 330B, and the second transistor layer 320B is adjacent to and between the second interconnect stack 330B and the third interconnect stack 330C (e.g., the second interconnect stack 330B between the first and second transistor layers 320A, 320B). The first, second, and third interconnect stacks 330A, 330B, 330C may each include one or more multiple interconnect layers, which may include lines and vias, the lines and vias including a conductive material 202 which may be the same as or similar to the conductive material 206 described above. While FIG. 2 illustrates the same conductive material 202 for the lines and the vias, at each interconnect layer, and for each type of interconnect (e.g., lines or vias), any suitable conductive material may be used. For example, in a given layer, the same conductive material may be used for both lines and vias, or different materials may be used for lines and vias. As another example, in different interconnect layers, different materials may be used for the lines and/or vias, e.g., ruthenium may be included in the lines in one interconnect layer, while copper is included in the lines of another interconnect layer. In various embodiments, line or via structures may include multiple conductive materials, e.g., a first metal as a liner, and a second metal as a fill. The conductive material 202 may form conductive pathways to route power, ground, and/or signals to/from various components of the first and/or second transistor layers 320A, 320B and/or first, second, and/or third interconnect stacks 330A, 330B, 330C. The arrangement of the conductive material 202 in FIG. 2 is merely illustrative, and the conductive pathways in the IC device 300 may be connected to one another in any suitable manner.

The IC device 300 may also include one or more etch stop layers 356. In FIG. 3, etch stop layers 356 are shown on either side of the first and second transistor layers 320A, 320B and in the first, second, and third interconnect stacks 330A, 330B, 330C (e.g., between or adjacent to individual interconnect layers of the first, second, and third interconnect stacks 330A, 330B, 330C). Similarly to the etch stop layers 256 described above with reference to FIG. 2, the etch stop layers 356 can prevent over-etching of components of the IC device 300 during various manufacturing processes (e.g., during formation of lines and/or vias in the first, second, and/or third interconnect stacks 330A, 330B, 330C), and may include an etch stop material 210, which may be the same etch stop material 210 described above with respect to FIG. 2. Although a certain number of etch stop layers 356 are shown, this is only to aid in understanding, and it should be understood that the IC device 300 may include additional etch stop layers 356 in order to avoid over etching of lines and/or vias, or may include fewer etch stop layers 356. Furthermore, although the etch stop layers 356 are shown in between lines or vias of some interconnect layers of the front side and back side interconnect layers, it should be understood that there may be openings in portions of the etch stop layers 356 not shown in FIG. 3 (e.g., along different z-y cross-sections of the IC device 300 outside of the view shown in FIG. 3) that may allow for physical and/or electrical communications between certain lines and/or vias in the interconnect layers as required for a given IC device 300.

The conductive lines and vias in the first, second, and third interconnect stacks 330A, 330B, 330C are in the dielectric material 106, which may include any of the materials described above with respect to the dielectric material 106. In some embodiments, different dielectric materials may be included in different ones of the interconnect layers in the interconnect stacks. In some embodiments, multiple dielectric materials may be present in a given interconnect layer.

The IC device 300 may also include liner segments or liners 360A-360P (collectively liner segments 360) adjacent to at least some of the conductive structures. The liner segments 360 may include a dielectric liner material 208 which may be the same as or similar to the dielectric liner material 208 described above with reference to FIG. 2. As shown, portions of the second conductive structure 350B (e.g., a sidewall 351C of the second conductive structure 350B between the first end 351A and the second end 351B) are adjacent to liner segments 360A, 360B, 360C, which are in the first interconnect stack 330A (e.g., in successive interconnect layers of the first interconnect stack 330A), to liner segment 360D, which is in the first transistor layer 320A, and to liner segment 360E, which is in the second interconnect stack 330B (e.g., in an interconnect layer of the second interconnect stack 330B adjacent to the first transistor layer 320A).

The liner segments 360A-360E may be between the etch stop layers 356 (for example, the liner segment 360D may be between etch stop layers 356 above and below the first transistor layer 320A, the liner segment 360B may be between etch stop layers 356 in the first interconnect stack 330A, etc.). At least some liner segments 360A-360E may be between the second conductive structure 350B and dielectric material 106 in interconnect layers (for example, the liner segment 360A may be between the second conductive structure 350B and dielectric material 106 in an interconnect layer in the first interconnect stack 330A), between the second conductive structure 350B and conductive material 202 in interconnect layers, and/or between the second conductive structure 350B and a transistor 100 or a portion of a transistor 100 (for example, the liner segment 360D may be between the second conductive structure 350B and the second and third transistors 315B, 315C (e.g., between the second conductive structure 350B and gate structures (such as the gate electrode 110 and the gate dielectric 112) of the second and third transistors 315B, 315C). The liner segments 360A-360E may be considered as multiple separate liner segments 360 or may be considered as parts of a single liner, which may be discontinuous (e.g., separated by portions of the etch stop layers 356).

Portions of the fourth conductive structure 350D (e.g., a sidewall 352C of the fourth conductive structure 350D between the first end 352A and the second end 352B) are adjacent to liner segments 360F, 360G, which are in the first interconnect stack 330A (e.g., in successive interconnect layers of the first interconnect stack 330A), to liner segment 360H, which is in the first transistor layer 320A, to liner segments 360I, 360J, 360K, 360L, 360M, 360N, which are in the second interconnect stack 330B (e.g., in successive interconnect layers of the second interconnect stack 230), to liner segment 360O, which is in the second transistor layer 320B, and to liner segment 360P, which is in the third interconnect stack 330C.

The liner segments 360F-360P may be between the etch stop layers 356 (for example, the liner segment 360H may be between etch stop layers 356 above and below the first transistor layer 320A, the liner segment 360F may be between etch stop layers 356 in the first interconnect stack 330A, etc.). At least some liner segments 360F-360O may be between the fourth conductive structure 350D and dielectric material 106 in interconnect layers (for example, the liner segment 360K may be between the fourth conductive structure 350D and dielectric material 106 in an interconnect layer in the second interconnect stack 330B), between the second conductive structure 350B and conductive material 202 in interconnect layers (for example, the liner segment 360J may be between the fourth conductive structure 350D and conductive material 202 in an interconnect layer in the second interconnect stack 330B), between conductive structures (for example, the liner segment 360O may be between the sixth conductive structure 350F and the fourth conductive structure 350D), and/or between the fourth conductive structure 350D and a transistor 100 or a portion of a transistor 100 (for example, the liner segment 360H may be between the fourth conductive structure 350D and the third and fourth transistors 315C, 315D (e.g., between the fourth conductive structure 350D and gate structures (such as the gate electrode 110 and the gate dielectric 112) of the third and fourth transistors 315C, 315D). The liner segments 360F-360P may be considered as multiple separate liner segments 360 or may be considered as parts of a single liner, which may be discontinuous (e.g., separated by portions of the etch stop layers 356).

Although multiple liner segments 360A-360P are shown at sidewalls 351C, 352C of the second and fourth conductive structures 350B, 350D, in some embodiments, more or fewer liners may be adjacent to the sidewalls 351C, 352C of the second and fourth conductive structures 350B, 350D. For example, in some embodiments, the liner segment 360B may not be present, and the portion of the sidewall 351C that would be adjacent to the liner segment 360B may instead be adjacent to only the dielectric material 106 or to another material in the first interconnect stack 330A.

FIG. 4 is a flow diagram of an example process 400 that may be used to manufacture an IC device having multi-layer conductive vias including etch-selective liners (such as the IC device 200), according to some embodiments of the present disclosure. FIGS. 5A-5H are side, cross-sectional views of various stages in the example process 400. Although the operations discussed below with reference to FIGS. 5A-5H (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 5A-5H may be modified in accordance with the present disclosure to fabricate others of transistor assemblies disclosed herein.

At 402, an IC assembly (e.g., an IC device or a portion of an IC device) including a transistor layer (e.g., an example of a device layer as noted above) may be provided. FIG. 5A shows an IC assembly 500A including a transistor layer 520. As shown, the transistor layer 520 includes four nanoribbon transistors 510A, 510B, 510C, 510D (collectively nanoribbon transistors 510), which may be the same as or similar to the nanoribbon transistors 215A, 215B, 215C, 215D described above with reference to FIG. 2. The nanoribbon transistors 510 may be formed as described above with respect to the transistor 100 (e.g., over a support structure 102, which may be removed after formation of the nanoribbon transistors 510), and may include the same or similar materials as the transistor 100, including the channel material 104, the gate electrode 110, and the gate dielectric 112. Between the nanoribbon transistors 510A and 510B and between the nanoribbon transistors 510C and 510D may be two zones 555A, 555B of dielectric material 106. The zones 555A, 555B (collectively zones 555) may be the same as or similar to the zones 255A, 255B described above with reference to FIG. 2, and may include the same dielectric material 106. The zones 555 may be formed between the nanoribbon transistors 510 using any suitable process. For example, the dielectric material 106 may be provided between the nanoribbon transistors 510 to form the zones 555 by a conformal deposition process (such as atomic layer deposition (ALD) or chemical vapor deposition (CVD)). Although four nanoribbon transistors 510A, 510B, 510C, 510D and two zones 555A, 555B are depicted in FIG. 5A, in other embodiments, greater or fewer numbers of nanoribbon transistors 510 and/or zones 555 may be provided in the IC assembly 500A.

The IC assembly 500A includes conductive structures 550A, 550B (e.g., conductive vias) including a conductive material 206 (which may be the same as the conductive material 206 described above with reference to FIG. 2). The conductive structures 550A, 550B may be provided by any suitable technique. For example, a photoresist material may be provided over portions of the transistor layer 520 by a suitable deposition technique such as, but not limited to, spin-coating, dip-coating, CVD, etc. Various materials that may be used as the photoresist material are well-known in the art, and therefore, for brevity, are not described here in detail. Part of the photoresist material may be removed (e.g., patterning the layer of photoresist material) by a technique known in the art, such as photolithographic patterning, to expose the zones 555A, 555B. Part of the dielectric material 106 may be removed from the zones 555A, 555B to form openings. The dielectric material 106 may be removed by any suitable technique known in the art, such as by an etching process (e.g., a dry etch technique such as e.g., radio frequency (RF) reactive ion etch (RIE) or inductively coupled plasma (ICP) RIE, or a wet etch technique). Leftover photoresist material (e.g., outside of the etched region) may be removed by any suitable process, including by an ashing technique, in which the photoresist material is exposed to oxygen or fluorine, which may combine with the photoresist material to form an ash that can be easily removed. The conductive material 206 may be provided in the openings in order to form the conductive structures 550A, 550B. The conductive material 206 may be provided in the openings by any suitable process, such as a conformal deposition process (e.g., ALD, CVD, etc.) or a non-conformal deposition process (e.g., a non-conformal electroless or electrolytic plating process). In some embodiments, additional processes (such as processes of cleaning surfaces of the conductive structures 550A, 550B) or fewer processes may be used to complete the formation of the conductive structures 550A, 550B. As part of the etching process for removing the dielectric material 106, first and second cavities 557A, 557B may be formed between the nanoribbon transistors 510B, 510C and between the nanoribbon transistors 510C, 510D, although in other embodiments, the cavities 557A, 557B may be formed at different times or through different processes.

The IC assembly 500A further includes liner segments 560A, 560B, which may be the same as or similar to the liner segments 260D, 260H described above with reference to FIG. 2, and may include a dielectric liner material 208, which may be the same as or similar to the dielectric liner material 208 described above with reference to FIG. 2. The liner segments 560A, 560B may be formed in any suitable manner. For example, the liner segments 560A, 560B may be formed using processes similar to those used in the formation of the conductive structures 550A, 550B (e.g., including processes of photolithography, etching, conformal plating, etc.). In some embodiments, the liner segments 560A, 560B may be formed in the cavities 557A, 557B after the etching process described above, although other suitable techniques for forming the liner segments 560A, 560B may be used.

The IC assembly further includes an etch stop layer 556, which may be the same as or similar to the etch stop layer 256 described above with reference to FIG. 2 and may include an etch stop material 210 which may be the same as the etch stop material 210 described above with reference to FIG. 2. The etch stop layer 556 may be deposited over the transistor layer 520 (e.g., after the formation of the dielectric material 106, conductive structures 550A, 550B, and liner segments 560A, 560B, or before, during, or after another process or set of processes). The etch stop layer 556 may be deposited by any suitable process, such as by a plasma deposition process (e.g., plasma enhanced CVD (PECVD)). In CVD processes, gaseous precursors are introduced into a deposition chamber; the precursors react with an exposed surface, leading to the formation of a layer (or multiple layers or films, over the surface. In PECVD, a plasma environment is used to enhance the deposition process. For example, the plasma can cause dissociation of precursor molecules and the creation of large quantities of free radicals. Furthermore, the plasma can expose deposited etch stop material 210 to energetic ion bombardment during deposition, which can lead to increases in the density of an etch stop layer and help remove contaminants, thus improving the layer's electrical and mechanical properties. The etch stop layer 556 may be patterned such that the cavities 557A, 557B are exposed (e.g., by combining the deposition process with any suitable technique, such as photolithography).

At 404, a front side interconnect stack may be formed over the front side of the IC assembly. FIG. 5B shows an IC assembly 500B, which may be the same as the IC assembly 500A, but after a process of forming a front side interconnect stack 530 over a front side of the IC assembly 500B (e.g., over the transistor layer 520). The front side interconnect stack 530 may be the same as or similar to the front side interconnect stack 230 described above with reference to FIG. 2, and the front side interconnect stack 530 may similarly include conductive lines and vias including a conductive material 202. The front side metallization stack 530 may be formed using any suitable technique or techniques, such as dual damascene techniques, single damascene techniques, subtractive metallization patterning techniques, etc. The formation of the front side interconnect stack 530 may include the formation of additional etch stop layers 556 adjacent to components of the front side interconnect stack 530 (e.g., adjacent to lines or vias). As a portion of the process for forming the front side interconnect stack 530, additional liner segments (e.g., liner segments 560C, 560D, 560E, 560F) may be deposited over etch stop layers 556 adjacent to at least some of the layers of the front side interconnect stack 530, and the cavities 557A, 557B may be extended into at least a portion of the front side interconnect stack 530 (e.g., by use of any suitable technique such as photolithography as described above).

At 406, the IC assembly may be flipped to expose a back side of the IC assembly. FIG. 5C shows an IC assembly 500C, which may be the same as the IC assembly 500B, but after a process of flipping the IC assembly 500B to expose a back side of the IC assembly 500B (e.g., such that the front side metallization stack 530 is at the bottom of the IC assembly 500C and an exposed portion of the transistor layer 520 is at the top of the IC assembly 500C as shown in FIG. 5C). The flipping may be conducted by any suitable process. For example, after formation of the front side metallization stack 530, a carrier structure may be attached to the top or front of the front side metallization stack 530, and the IC assembly 500B may be flipped to the orientation of the IC assembly 500C shown in FIG. 5C.

At 408, the first part of a back side interconnect stack may be formed over a back side of the IC assembly. FIG. 5D shows an IC assembly 500D, which may be the same as the IC assembly 500C, but after a process of forming a first part of a back side interconnect stack 540A over the back side of the IC assembly 500C (e.g., over the top of the transistor layer 520 shown in FIG. 5C). The first part of the back side interconnect stack 540A may be formed using any suitable technique or techniques, such as dual damascene techniques, single damascene techniques, subtractive metallization patterning techniques, etc. Similarly to the formation of the front side interconnect stack 530, the formation of the first part of the back side interconnect stack 540A may include the formation of additional etch stop layers 556 adjacent to components of the first part of the back side interconnect stack 540A (e.g., adjacent to lines or vias in interconnect layers of the first part of the back side interconnect stack 540A), additional liner segments (e.g., liner segments 560G, 560H, 560I, 560J) may be deposited over etch stop layers 556 adjacent to interconnect layers of the first part of the back side interconnect stack 540A, and the cavities 557A, 557B may be extended into at least a portion of the first part of the back side interconnect stack 540A (e.g., by use of any suitable technique such as photolithography as described above).

At 410, the first cavities in the IC assembly may be provided with a conductive material. FIG. 5E shows an IC assembly 500E, which may be the same as the IC assembly 500D, but after a process of providing conductive material 206 (which may be the same as conductive material 206 described above with reference to FIG. 2) to the first cavity 557A (shown in FIG. 5D), resulting in the formation of conductive structure 550C (which may be the same as the conductive structure 250C described above with reference to FIG. 2). The conductive material 206 may be provided to the first cavity 557A by any suitable technique, including a conformal deposition process or a non-conformal deposition process similar to those described above for provision of the conductive structures 550A, 550B. The conductive structure 550C may be deposited adjacent to the liner segments 560B, 560D, 560E, 560F, 560G, 560I. Advantageously, the liner segments 560B, 560D, 560E, 560F, 560G, 560I may help to limit or restrict the position of the conductive structure 550C relative to other vias and/or lines in the interconnect layers of the IC assembly 500E, allowing for reliable electrical connections to be made between the conductive structure 550C and the other vias and/or lines.

At 412, an additional n number of parts of the back side interconnect stack including liner material may be formed over the back side of the IC assembly, and additional nth cavities in the IC assembly may be filled. FIG. 5F shows an IC assembly 500F, which may be the same as the IC assembly 500E, but after a process of forming a second part of a back side interconnect stack 540B over the back side of the IC assembly 500E (e.g., over the top of the first part of the back side interconnect stack 540A shown in FIG. 5E). Similarly to the formation of the first part of the back side interconnect stack 540A, the second part of the back side interconnect stack 540B may be formed using any suitable technique or techniques, such as dual damascene techniques, single damascene techniques, subtractive metallization patterning techniques, etc., and the formation process may include the formation of an additional etch stop layer 556, and an additional liner segment (e.g., liner segment 560K) may be deposited over the additional etch stop layer 556. The cavity 557B may be extended into the second part of the back side interconnect stack 540B. FIG. 5G shows an IC assembly 500G, which may be the same as the IC assembly 500F, but after a process of providing conductive material 206 to the second cavity 557B (shown in FIG. 5F), forming conductive structure 550D. The conductive material 206 may be provided to the second cavity 557B by any suitable technique, including a conformal deposition process or a non-conformal deposition process similar to that described above for provision of conductive material 206 to the first cavity 557A. The conductive structure 550D may be deposited adjacent to the liner segments 560A, 560C, 560H, 560J, 560K. Advantageously, the liner segments 560A, 560C, 560H, 560J, 560K may help to limit or restrict the position of the conductive structure 550D relative to other vias and/or lines in the interconnect layers of the IC assembly 500G. In some embodiments, 414 of FIG. 4 may involve formation of additional parts of the back side interconnect stack and/or formation of additional conductive structures in additional cavities of an IC assembly.

At 414, the back side interconnect stack may be completed over the back side of the IC assembly. FIG. 5H shows an IC assembly 500H, which may be the same as the IC assembly 500G, but after a process of forming a third part of the back side interconnect stack 540C over the back side of the IC assembly 500G (e.g., over the top of the second part of the back side interconnect stack 540B of the IC assembly 500G shown in FIG. 5G). The IC assembly 500H, if flipped such that the front side interconnect stack 530 is at the top of the IC assembly 500H (e.g., over the transistor layer 520) and such that the first, second, and third parts of the back side interconnect stack 540A, 540B, 540C are at the bottom of the IC assembly 500H (e.g., under the transistor layer 520), may be the same as or similar to the IC device 200 described above with reference to FIG. 2. The third part of the back side interconnect stack 540C may be formed using any suitable technique or techniques, such as dual damascene techniques, single damascene techniques, subtractive metallization patterning techniques, etc.

The IC devices disclosed herein (e.g., having one or more multi-layer conductive vias including one or more etch-selective liners) may be included in or associated with any suitable apparatus. FIGS. 6-9 illustrate various examples of apparatuses that may include one or more of the IC devices, which may have been fabricated using the processes disclosed herein.

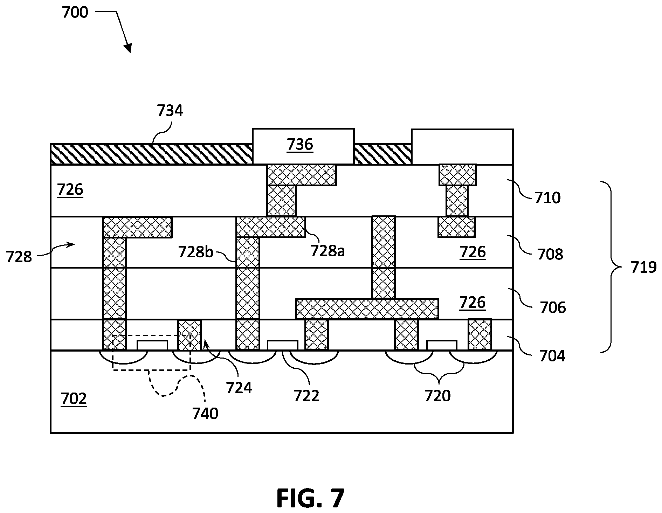

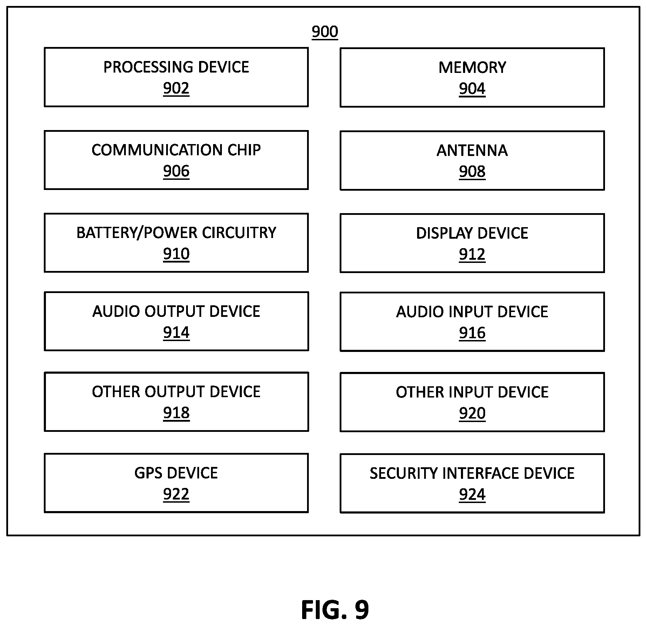

FIG. 6A and 6B are top views of a wafer and dies that include one or more IC devices in accordance with any of the embodiments disclosed herein. The wafer 600 may be composed of semiconductor material and may include one or more dies 602 having IC devices formed on a surface of the wafer 600. Each of the dies 602 may be a repeating unit of a semiconductor product that includes any suitable IC devices (e.g., IC devices as shown in or described with reference to any of FIGS. 1-5, or any further embodiments of the IC devices described herein). After the fabrication of the semiconductor product is complete (e.g., after manufacture of one or more IC devices as described herein, included in a particular electronic component, e.g., in a transistor device or in a memory device), the wafer 600 may undergo a singulation process in which each of the dies 602 is separated from one another to provide discrete "chips" of the semiconductor product. In particular, devices that include one or more of the IC devices as disclosed herein may take the form of the wafer 600 (e.g., not singulated) or the form of the die 602 (e.g., singulated). The die 602 may include one or more transistors (e.g., one or more of the transistors 100 of FIG. 1 discussed above or transistors 740 of FIG. 7, discussed below) and/or supporting circuitry to route electrical signals to the transistors, as well as any other IC components (e.g., one or more of the devices described herein). In some embodiments, the wafer 600 or the die 602 may include a memory device (e.g., a static random-access memory or SRAM device), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processing device (e.g., the processing device 902 of FIG. 9) or other logic that is configured to store information in the memory devices or execute instructions stored in the memory array.

FIG. 7 is a cross-sectional side view of an IC device 700 that may be or include one or more IC devices in accordance with any of the embodiments disclosed herein (e.g., embodiments described above with reference to FIGS. 1-5), at any suitable location in the IC device 700. The IC device 700 may be formed on a substrate 702 (e.g., the wafer 600 of FIG. 6A) and may be included in a die (e.g., the die 602 of FIG. 6B). The substrate 702 may be any substrate as described herein. The substrate 702 may be part of a singulated die (e.g., the dies 602 of FIG. 6B) or a wafer (e.g., the wafer 600 of FIG. 6A).

The IC device 700 may include a device layer 704 (which may be the same as or similar to the transistor layer 220 of FIG. 2) disposed on the substrate 702. In some embodiments, more than one device layer 704 may be included. The device layer 704 may include features of one or more transistors 740 (e.g., metal oxide semiconductor field effect transistors (MOSFETs)) formed on the substrate 702. The device layer 704 may include, for example, one or more source and/or drain (S/D) regions 720, a gate 722 to control current flow in the transistors 740 between the S/D regions 720, and one or more S/D contacts 724 to route electrical signals to/from the S/D regions 720. The transistors 740 may include additional features not depicted for the sake of clarity, such as device isolation regions, gate contacts, and the like. The transistors 740 are not limited to the type and configuration depicted in FIG. 7 and may include a wide variety of other types and configurations such as, for example, planar transistors, non-planar transistors, or a combination of both. Non-planar transistors may include fin-type field effect transistors (FinFETs), such as double-gate transistors or tri-gate transistors, and wrap-around or all-around gate transistors, such as nanoribbon and nanowire transistors.

Each transistor 740 may include a gate 722 formed of at least two layers, a gate electrode layer and a gate dielectric layer. The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer may enable the formation of a PMOS gate electrode with a workfunction that is between about 4.9 electron Volts (eV) and about 5.2 eV, for example. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer may enable the formation of an NMOS gate electrode with a workfunction that is between about 3.9 eV and about 4.2 eV, for example.

In some embodiments, when viewed as a cross-section of the transistor 740 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 740 may include one layer or a stack of layers, and the one or more layers may include silicon oxide, silicon dioxide, and/or a high-k dielectric material. The high-k dielectric material included in the gate dielectric layer of the transistor 740 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The S/D regions 720 may be formed within the substrate 702 adjacent to the gate 722 of each transistor 740, using any suitable processes known in the art. For example, the S/D regions 720 may be formed using either an implantation/diffusion process or a deposition process. In the former process, dopants such as boron, aluminum, antimony, phosphorous, or arsenic may be ion-implanted into the substrate 702 to form the S/D regions 720. An annealing process that activates the dopants and causes them to diffuse farther into the substrate 702 may follow the ion implantation process. In the latter process, an epitaxial deposition process may provide material that is used to fabricate the S/D regions 720. In some implementations, the S/D regions 720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 720 may be formed using one or more alternate semiconductor materials such as germanium or a group III-V material or alloy. In further embodiments, one or more layers of metal and/or metal alloys may be used to form the S/D regions 720. In some embodiments, an etch process may be performed before the epitaxial deposition to create recesses in the substrate 702 in which the material for the S/D regions 720 is deposited.

Electrical signals, such as power and/or input/output (I/O) signals, may be routed to and/or from the transistors 740 of the device layer 704 through one or more interconnect layers disposed on the device layer 704 (illustrated in FIG. 7 as interconnect layers 706-710). For example, electrically conductive features of the device layer 704 (e.g., the gate 722 and the S/D contacts 724) may be electrically coupled with the interconnect structures 728 of the interconnect layers 706-710. The one or more interconnect layers 706-709 may form an ILD stack 719 of the IC device 700.

The interconnect structures 728 may be arranged within the interconnect layers 706-710 to route electrical signals according to a wide variety of designs (in particular, the arrangement is not limited to the particular configuration of interconnect structures 728 depicted in FIG. 7). Although a particular number of interconnect layers 706-710 is depicted in FIG. 7, embodiments of the present disclosure include IC devices having more or fewer interconnect layers than depicted.

In some embodiments, the interconnect structures 728 may include lines 728a and/or vias 728b filled with an electrically conductive material such as a metal. The lines 728a may be arranged to route electrical signals in a direction of a plane that is substantially parallel with a surface of the substrate 702 upon which the device layer 704 is formed. For example, the lines 728a may route electrical signals in a direction in and out of the page from the perspective of FIG. 7. The vias 728b may be arranged to route electrical signals in a direction of a plane that is substantially perpendicular to the surface of the substrate 702 upon which the device layer 704 is formed. In some embodiments, the vias 728b may electrically couple lines 728a of different interconnect layers 706-710 together.

The interconnect layers 706-710 may include a dielectric material 726 disposed between the interconnect structures 728, as shown in FIG. 7. The dielectric material 726 may take the form of any of the embodiments of the dielectric material provided between the interconnects of the IC structures disclosed herein.

In some embodiments, the dielectric material 726 disposed between the interconnect structures 728 in different ones of the interconnect layers 706-710 may have different compositions. In other embodiments, the composition of the dielectric material 726 between different interconnect layers 706-710 may be the same.

A first interconnect layer 706 (referred to as metal 1 or "M1") may be formed directly on the device layer 704. In some embodiments, the first interconnect layer 706 may include lines 728a and/or vias 728b, as shown. The lines 728a of the first interconnect layer 706 may be coupled with contacts (e.g., the S/D contacts 724) of the device layer 704.

A second interconnect layer 708 (referred to as metal 2 or "M2") may be formed directly on the first interconnect layer 706. In some embodiments, the second interconnect layer 708 may include vias 728b to couple the lines 728a of the second interconnect layer 708 with the lines 728a of the first interconnect layer 706. Although the lines 728a and the vias 728b are structurally delineated with a line within each interconnect layer (e.g., within the second interconnect layer 708) for the sake of clarity, the lines 728a and the vias 728b may be structurally and/or materially contiguous (e.g., simultaneously filled during a dual damascene process) in some embodiments.

A third interconnect layer 710 (referred to as metal 3 or "M3") (and additional interconnect layers, as desired) may be formed in succession on the second interconnect layer 708 according to similar techniques and configurations described in connection with the second interconnect layer 708 or the first interconnect layer 706.

The IC device 700 may include a solder resist material 734 (e.g., polyimide or similar material) and one or more bond pads 736 formed on the interconnect layers 706-710. The bond pads 736 may be electrically coupled with the interconnect structures 728 and configured to route the electrical signals of the transistor(s) 740 to other external devices. For example, solder bonds may be formed on the one or more bond pads 736 to mechanically and/or electrically couple a chip including the IC device 700 with another component (e.g., a circuit board). The IC device 700 may have other alternative configurations to route the electrical signals from the interconnect layers 706-710 than depicted in other embodiments. For example, the bond pads 736 may be replaced by or may further include other analogous features (e.g., posts) that route the electrical signals to external components.

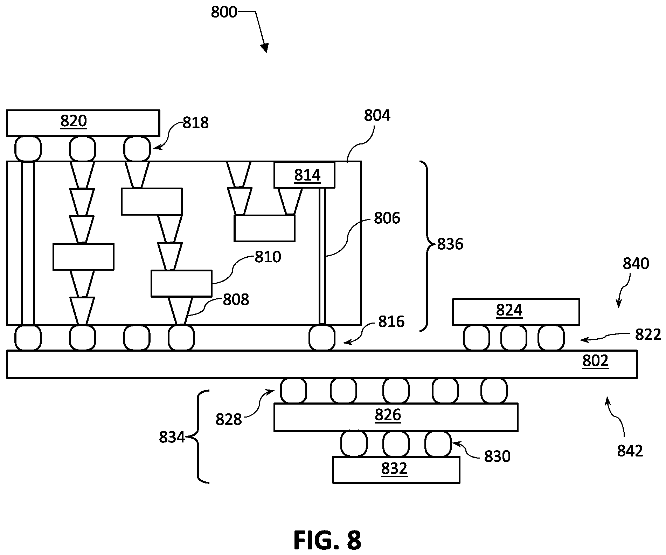

FIG. 8 is a cross-sectional side view of an IC device assembly 800 that may include or be associated with (e.g., being electrically connected to) one or more IC devices having one or more multi-layer conductive vias including one or more etch-selective liners, in accordance with any of the embodiments disclosed herein. The IC device assembly 800 includes a number of components disposed on a circuit board 802 (which may be, e.g., a motherboard). The IC device assembly 800 includes components disposed on a first face 840 of the circuit board 802 and an opposing second face 842 of the circuit board 802; generally, components may be disposed on one or both faces 840 and 842. Any suitable ones of the components of the IC device assembly 800 may include one or more multi-layer conductive vias including one or more etch-selective liners disclosed herein.

In some embodiments, the circuit board 802 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate.

The IC device assembly 800 illustrated in FIG. 8 includes a package-on-interposer structure 836 coupled to the first face 840 of the circuit board 802 by coupling components 816. The coupling components 816 may electrically and mechanically couple the package-on-interposer structure 836 to the circuit board 802 and may include solder balls (as shown in FIG. 8), male and female portions of a socket, an adhesive, an underfill material, and/or any other suitable electrical and/or mechanical coupling structure.

The package-on-interposer structure 836 may include an IC package 820 coupled to an interposer 804 by coupling components 818. The coupling components 818 may take any suitable form for the application, such as the forms discussed above with reference to the coupling components 816. Although a single IC package 820 is shown in FIG. 8, multiple IC packages may be coupled to the interposer 804; indeed, additional interposers may be coupled to the interposer 804. The interposer 804 may provide an intervening substrate used to bridge the circuit board 802 and the IC package 820. The IC package 820 may be or include, for example, a die (the die 602 of FIG. 6B), an IC device (e.g., the IC device 200 of FIG. 2, the IC device 300 of FIG. 3, the IC device 700 of FIG. 7, etc.), or any other suitable component. Generally, the interposer 804 may spread a connection to a wider pitch or reroute a connection to a different connection. For example, the interposer 804 may couple the IC package 820 (e.g., a die, such as the die 602 of FIG. 6B) to a ball grid array (BGA) of the coupling components 816 for coupling to the circuit board 802. In the embodiment illustrated in FIG. 8, the IC package 820 and the circuit board 802 are attached to opposing sides of the interposer 804; in other embodiments, the IC package 820 and the circuit board 802 may be attached to a same side of the interposer 804. In some embodiments, three or more components may be interconnected by way of the interposer 804.

The interposer 804 may be formed of an epoxy resin, a fiberglass-reinforced epoxy resin, a ceramic material, or a polymer material such as polyimide. In some implementations, the interposer 804 may be formed of alternate rigid or flexible materials that may include the same materials described above for use in a semiconductor substrate, such as silicon, germanium, and other group III-V and group IV materials. The interposer 804 may include metal interconnects 810 and vias 808 (including but not limited to vias 806, which may be through vias). The interposer 804 may further include embedded devices 814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art.

The IC device assembly 800 may include an IC package 824 coupled to the first face 840 of the circuit board 802 by coupling components 822. The coupling components 822 may take the form of any of the embodiments discussed above with reference to the coupling components 816, and the IC package 824 may take the form of any of the embodiments discussed above with reference to the IC package 820.

The IC device assembly 800 illustrated in FIG. 8 includes a package-on-package structure 834 coupled to the second face 842 of the circuit board 802 by coupling components 828. The package-on-package structure 834 may include an IC package 826 and an IC package 832 coupled together by coupling components 830 such that the IC package 826 is disposed between the circuit board 802 and the IC package 832. The coupling components 828 and 830 may take the form of any of the embodiments of the coupling components 816 discussed above, and the IC packages 826 and 832 may take the form of any of the embodiments of the IC package 820 discussed above. The package-on-package structure 834 may be configured in accordance with any of the package-on-package structures known in the art.

FIG. 9 is a block diagram of an example computing device 900 that may include one or more IC devices having one or more multi-layer conductive vias including one or more etch-selective liners, in accordance with any of the embodiments disclosed herein. For example, any suitable ones of the components of the computing device 900 may include a die (e.g., the die 602 of FIG. 6B) having one or more IC devices having one or more multi-layer conductive vias including one or more etch-selective liners. Any one or more of the components of the computing device 900 may include, or be included in, an IC device (e.g., the IC device 200, the IC device 300, the IC device 700 of FIG. 7, or another IC device disclosed herein). Any one or more of the components of the computing device 900 may include, or be included in, an IC device assembly (e.g., the IC device assembly 800 of FIG. 8).

A number of components are illustrated in FIG. 9 as included in the computing device 900, but any one or more of these components may be omitted or duplicated, as suitable for the application. In some embodiments, some or all of the components included in the computing device 900 may be attached to one or more motherboards. In some embodiments, some or all of these components are fabricated onto a single system-on-a-chip (SoC) die.

Additionally, in various embodiments, the computing device 900 may not include one or more of the components illustrated in FIG. 9, but the computing device 900 may include interface circuitry for coupling to the one or more components. For example, the computing device 900 may not include a display device 912, but may include display device interface circuitry (e.g., a connector and driver circuitry) to which a display device 912 may be coupled. In another set of examples, the computing device 900 may not include an audio input device 916 or an audio output device 914, but may include audio input or output device interface circuitry (e.g., connectors and supporting circuitry) to which an audio input device 916 or audio output device 914 may be coupled.

The computing device 900 may include a processing device 902 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 902 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 900 may include a memory 904, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 904 may include memory that shares a die with the processing device 902. This memory may be used as cache memory and may include embedded dynamic random-access memory (eDRAM) or spin transfer torque magnetic random-access memory (STT-MRAM).

In some embodiments, the computing device 900 may include a communication chip 906 (e.g., one or more communication chips). For example, the communication chip 906 may be configured for managing wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 906 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 906 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 906 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 906 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 906 may operate in accordance with other wireless protocols in other embodiments. The computing device 900 may include an antenna 908 to facilitate wireless communications and/or to receive other wireless communications (such as AM or FM radio transmissions).

In some embodiments, the communication chip 906 may manage wired communications, such as electrical, optical, or any other suitable communication protocols (e.g., the Ethernet). As noted above, the communication chip 906 may include multiple communication chips. For instance, a first communication chip 906 may be dedicated to shorter-range wireless communications such as Wi-Fi or Bluetooth, and a second communication chip 906 may be dedicated to longer-range wireless communications such as global positioning system (GPS), EDGE, GPRS, CDMA, WiMAX, LTE, EV-DO, or others. In some embodiments, a first communication chip 906 may be dedicated to wireless communications, and a second communication chip 906 may be dedicated to wired communications.

The computing device 900 may include a battery/power circuitry 910. The battery/power circuitry 910 may include one or more energy storage devices (e.g., batteries or capacitors) and/or circuitry for coupling components of the computing device 900 to an energy source separate from the computing device 900 (e.g., AC line power).

The computing device 900 may include a display device 912 (or corresponding interface circuitry, as discussed above). The display device 912 may include any visual indicators, such as a heads-up display, a computer monitor, a projector, a touchscreen display, a liquid crystal display (LCD), a light-emitting diode display, or a flat panel display, for example.

The computing device 900 may include an audio output device 914 (or corresponding interface circuitry, as discussed above). The audio output device 914 may include any device that generates an audible indicator, such as speakers, headsets, or earbuds, for example.

The computing device 900 may include an audio input device 916 (or corresponding interface circuitry, as discussed above). The audio input device 916 may include any device that generates a signal representative of a sound, such as microphones, microphone arrays, or digital instruments (e.g., instruments having a musical instrument digital interface (MIDI) output).

The computing device 900 may include an other output device 918 (or corresponding interface circuitry, as discussed above). Examples of the other output device 918 may include an audio codec, a video codec, a printer, a wired or wireless transmitter for providing information to other devices, or an additional storage device.

The computing device 900 may include an other input device 920 (or corresponding interface circuitry, as discussed above). Examples of the other input device 920 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 900 may include a GPS device 922 (or corresponding interface circuitry, as discussed above). The GPS device 922 may be in communication with a satellite-based system and may receive a location of the computing device 900, as known in the art.

The computing device 900 may include a security interface device 924. The security interface device 924 may include any device that provides security features for the computing device 900 or for any individual components therein (e.g., for the processing device 902 or for the memory 904). Examples of security features may include authorization, access to digital certificates, access to items in keychains, etc. Examples of the security interface device 924 may include a software firewall, a hardware firewall, an antivirus, a content filtering device, or an intrusion detection device.

The computing device 900 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 900 may be any other electronic device that processes data.

The following paragraphs provide various examples of the embodiments disclosed herein.

Example 1 provides an IC device that includes a first metallization layer; a second metallization layer; a transistor layer between the first metallization layer and the second metallization layer, the transistor layer including a first gate structure and a second gate structure; and a conductive via between the first gate structure and the second gate structure, the conductive via extending through the first metallization layer and extending at least partially into the second metallization layer.

Example 2 provides the IC device of example 1, in which the conductive via extends through the first metallization layer to a first end and extends at least partially into the second metallization layer to a second end, and a width of the conductive via increases from the first end to the second end.

Example 3 provides the IC device of example 1, in which the conductive via has a first end, a second end, and a length between the first end and the second end, and the conductive via tapers in width along the length.

Example 4 provides the IC device of any one of examples 1-3, further including a liner adjacent to at least a portion of the conductive via, the liner including a dielectric material.

Example 5 provides the IC device of example 4, in which the liner is adjacent to at least a segment of a sidewall of the conductive via.

Example 6 provides the IC device of example 5, in which the liner is discontinuous along the segment.

Example 7 provides the IC device of example 5 or 6, in which the segment is a first segment, the dielectric material is a first dielectric material, and a second segment of the sidewall is adjacent to a second dielectric material different from the first dielectric material.

Example 8 provides the IC device of any one of examples 4-7, in which at least part of the liner is between the conductive via and the first gate structure.

Example 9 provides the IC device of any one of examples 4-8, in which at least part of the liner is between the conductive via and a metal structure in the first metallization layer.

Example 10 provides the IC device of any one of examples 4-9, in which the liner includes at least one of hafnium, tantalum, titanium, aluminum, and silicon.

Example 11 provides the IC device of example 10, in which the liner further includes at least one of oxygen or nitrogen.

Example 12 provides the IC device of any one of examples 4-11, in which double of a thickness of the liner is less than 50% of a width of the conductive via.

Example 13 provides the IC device of any one of examples 4-12, in which the liner is a first liner, the portion is a first portion, and the IC device further includes a second liner adjacent to a second portion of the conductive via.

Example 14 provides the IC device of any one of examples 1-13, in which the conductive via has an aspect ratio of at least 3:1.

Example 15 provides the IC device of any one of examples 1-14, in which the transistor layer is a first transistor layer, the IC device further includes a second transistor layer including a third gate structure and a fourth gate structure, and the conductive via is between the third gate structure and the fourth gate structure.

Example 16 provides the IC device of example 15, in which the second transistor layer is between the second metallization layer and a third metallization layer.

Example 17 provides the IC device of any one of examples 1-16, in which the conductive via is a first conductive via, and the IC device further includes a second conductive via between the first gate structure and the second gate structure.

Example 18 provides the IC device of example 17, in which a first height of the first conductive via is greater than a second height of the second conductive via.

Example 19 provides an IC device that includes a first layer including a first conductive feature; a second layer including a second conductive feature; an elongated conductive structure including a first end joined to the first conductive feature, a second end joined to the second conductive feature, and a sidewall between the first end and the second end; a liner in contact with at least a portion of the sidewall; and a transistor structure, in which a plane substantially perpendicular to a longitudinal axis of the elongated conductive structure includes a portion of the transistor structure and a portion of the elongated conductive structure.

Example 20 provides the IC device of example 19, in which at least a portion of the transistor structure is between the first layer and the second layer.

Example 21 provides the IC device of example 19 or 20, in which the transistor structure is a first transistor structure, and the IC device further includes a second transistor structure, in which at least a portion of the elongated conductive structure is between the first transistor structure and the second transistor structure.

Example 22 provides the IC device of any one of examples 19-21, in which the liner is a first liner, the portion of the sidewall is a first portion of the sidewall, and the IC device further includes a second liner, the second liner in contact with a second portion of the sidewall.

Example 23 provides the IC device of example 22, in which the second liner is further in contact with a third conductive feature.

Example 24 provides the IC device of example 23, in which the first layer is on a first side of the transistor structure, the second layer is on a second side of the transistor structure, and the third conductive feature is on the first side of the transistor structure.

Example 25 provides a microelectronic assembly, including a packaging component; and a die coupled to the packaging component, the die including a first layer including a logic or memory device; a first metal structure in a second layer on a first side of the first layer; a second metal structure in a third layer on a second side of the first layer, the second side opposite the first side; and a via extending between the first metal structure and the second metal structure.

Example 26 provides the microelectronic assembly of example 25, in which the via extends through the first layer.

Example 27 provides the microelectronic assembly of examples 25 or 26, in which the logic or memory device includes a first gate electrode and a second gate electrode, and at least a portion of the via is between the first gate electrode and the second gate electrode.

Example 28 provides the microelectronic assembly of any one of examples 25-27, in which the logic or memory device is a first logic or memory device, and the assembly further includes a fourth layer including a second logic or memory device, in which at least a portion of the via is in the fourth layer.

Example 29 provides the microelectronic assembly of example 28, in which the via extends through the fourth layer.

Example 30 provides the microelectronic assembly of examples 28 or 29, in which the second logic or memory device includes a first transistor structure and a second transistor structure, and at least a portion of the via is between the first transistor structure and the second transistor structure.

## Claims

1. An integrated circuit (IC) device, comprising:
a first metallization layer;
a second metallization layer;
a transistor layer between the first metallization layer and the second metallization layer, the transistor layer comprising a first gate structure and a second gate structure; and
a conductive via between the first gate structure and the second gate structure, the conductive via extending through the first metallization layer and extending at least partially into the second metallization layer.

2. The IC device of claim 1, further comprising a liner adjacent to at least a portion of the conductive via, the liner comprising a dielectric material.

3. The IC device of claim 2, wherein the liner is adjacent to at least a segment of a sidewall of the conductive via.

4. The IC device of claim 3, wherein the liner is discontinuous along the segment.

5. The IC device of claim 3 or 4, wherein the segment is a first segment, the dielectric material is a first dielectric material, and a second segment of the sidewall is adjacent to a second dielectric material different from the first dielectric material.

6. The IC device of one of the claims 2-5, wherein at least part of the liner is between the conductive via and the first gate structure.

7. The IC device of one of the claims 2-6, wherein at least part of the liner is between the conductive via and a metal structure in the first metallization layer.

8. The IC device of one of the claims 2-7, wherein the liner includes at least one of hafnium, tantalum, titanium, aluminum, and silicon.

9. The IC device of claim 8, wherein the liner further includes oxygen or nitrogen.

10. The IC device of any one of claims 1-9, wherein the conductive via has an aspect ratio of at least 3:1.

11. The IC device of any one of claims 1-10, wherein the transistor layer is a first transistor layer, the IC device further comprises a second transistor layer comprising a third gate structure and a fourth gate structure, and the conductive via is between the third gate structure and the fourth gate structure.

12. The IC device of claim 11, wherein the second transistor layer is between the second metallization layer and a third metallization layer.

13. The IC device of any one of claims 1-12, wherein the conductive via is a first conductive via, and the IC device further comprises a second conductive via between the first gate structure and the second gate structure.

14. The IC device of claim 13, wherein a height of the first conductive via is greater than a height of the second conductive via.

15. A microelectronic assembly, comprising:
a packaging component; and
the IC device of any one of claims 1-14 coupled to the packaging component.
